# EUROPÄISCHE PATENTSCHRIFT

(11) **EP 3 008 519 B1**
(45) Veröffentlichungstag und Bekanntmachung des Hinweises auf die Patenterteilung: **09.08.2017**
(21) Anmeldenummer: 14730839.9
(22) Anmeldetag: 12.06.2014
(51) Int. Cl.: G03F 7/11, B41C 1/10, G03F 7/09

(54) **DIGITAL BEBILDERBARES FLEXODRUCKELEMENT MIT POLARER, ULTRADÜNNER BARRIERESCHICHT**
DIGITALLY PRINTABLE FLEXOGRAPHIC PRINTING ELEMENT WITH A POLAR, ULTRATHIN BARRIER LAYER
ELÉMENT POUR LA FLEXOGRAPHIE NUMÉRIQUE AVEC UNE COUCHE BARRIÈRE POLAIRE ET ULTRAMINCE

(30) Priorität: 14.06.2013 EP 13172084
(43) Veröffentlichungstag der Anmeldung: 20.04.2016
(73) Patentinhaber: Flint Group Germany GmbH, 70469 Stuttgart (DE)
(72) Erfinder: BECKER, Armin, 67259 Großniedesheim (DE); BEYER, Matthias, 76327 Pfinztal (DE); REIFSCHNEIDER, Andreas, 68159 Mannheim (DE); RIEWE, Denis, 77731 Willstätt (DE); STEBANI, Uwe, 67592 Flörsheim-Dalsheim (DE)
(74) Vertreter: Schuck, Alexander
(86) Internationale Anmeldenummer: PCT/EP2014/062194
(87) Internationale Veröffentlichungsnummer: WO 2014/198809

(56) Entgegenhaltungen:
- EP-A1- 0 697 967
- EP-A1- 2 284 612

## Beschreibung

Die vorliegende Erfindung betrifft digital bebilderbare Flexodruckelemente, die zur Herstellung von Flexodruckplatten eingesetzt werden können, welche unter Verwendung von Kohlenwasserstoffe umfassenden Auswaschmitteln entwickelbar sind und welche zwischen der fotopolymerisierbaren Schicht und der digital bebilderbaren Schicht eine polare, ultradünne, gegen Sauerstoff sperrende Barriereschicht ausweisen. Die Erfindung betrifft weiterhin ein Verfahren zur Herstellung von Flexodruckplatten unter Verwendung derartiger digital bebilderbarer Flexodruckelemente durch Bebildern, Belichten, Auswaschen, Trocknen und Nachbehandlung, wobei man das Auswaschen mittels Kohlenwasserstoffe umfassender Auswaschmittel vornimmt.

Digital bebilderbare Flexodruckelemente sind prinzipiell bekannt. Sie umfassen mindestens einen dimensionsstabilen Träger, eine fotopolymerisierbare Schicht sowie eine digital bebilderbare Schicht. Bei der digital bebilderbaren Schicht kann es sich beispielsweise um eine laserablatierbare Schicht, um eine mittels Ink-Jet-Drucker beschreibbare Schicht oder um eine thermographische Schicht handeln, wobei laserablatierbare Schichten am gebräuchlichsten sind.

Laserablatierbare Schichten, auch LAMS (laserablatierbare Maskenschichten) genannt, sind für die Wellenlänge des aktinischen Lichtes opak und umfassen üblicherweise ein Bindemittel sowie mindestens einen IR-Absorber wie beispielsweise Ruß. Ruß bewirkt auch, dass die Schicht opak ist. In die laserablatierbare Schicht kann mittels eines IR-Lasers eine Maske eingeschrieben werden, d.h. die Schicht wird an den Stellen, an denen sie vom Laserstrahl getroffen wird, zersetzt und die darunter angeordnete fotopolymersierbare Schicht wird freigelegt. Die laserablatierbare Maskenschicht kann unmittelbar auf die fotopolymersierbare Schicht aufgebracht werden, oder zwischen der fotopolymerisierbaren Schicht und der laserablatierbaren Maskenschicht können sich noch weitere Schichten befinden, beispielsweise eine Sperrschicht. Beispiele für die Bebilderung von Flexodruckelementen mit IR-ablativen Masken sind beispielsweise in US 5,262,275 oder EP-A 1 069 475 offenbart.

Die Herstellung von Flexodruckformen ausgehend von fotopolymerisierbaren, digital bebilderbaren Flexodruckelementen erfolgt wie folgt: Nach dem Einschreiben einer Maske in die digital bebilderbare Schicht wird das Flexodruckelement durch die Maske hindurch mit UV-Strahlung bzw. UV/VIS-Strahlung belichtet. Die fotopolymerisierbare Schicht polymerisiert in den von der Maske nicht mehr abgedeckten Bereichen, während in den abgedeckten Bereichen keine Polymerisation erfolgt. Nach der Belichtung werden die Reste der Maske sowie die nicht polymerisierten Anteile der fotopolymerisierbaren Schicht entfernt. Dies kann unter Verwendung von einem oder mehreren Lösemitteln oder auch thermisch erfolgen. Bei Verwendung von Lösemitteln schließt sich ein Trockenschritt an. Üblicherweise wird die erhaltene Flexodruckform noch nachbehandelt, beispielsweise durch Belichten mit UVA- und/oder UVC-Licht.

Bei digital bebilderbaren Flexodruckelementen erfolgt die Hauptbelichtung mittels UV- bzw. UV/VIS-Strahlung üblicherweise in Gegenwart von Luftsauerstoff.

Es ist bekannt, dass bei der Hauptbelichtung die Anwesenheit von Sauerstoff einen ganz erheblichen Einfluss auf die Form der druckenden Reliefelemente hat, ganz besonders auf die Form feiner Rasterelemente. Molekularer Sauerstoff ist bekanntlich ein Diradikal und kann daher mit anderen Radikalen reagieren. Die Anwesenheit von molekularem Sauerstoff während der durch UV-Licht ausgelösten radikalischen Polymerisation führt dazu, dass der Sauerstoff die Radikalkettenreaktion an der Oberfläche der fotopolymerisierbaren Schicht unterbricht und somit die Oberfläche der Reliefelemente nicht mehr ausreichend polymerisiert. Weiter unterhalb der Oberfläche gelegene Bereiche der fotopolymerisierbaren Schicht werden weniger beeinflusst. Im Zuge der Entwicklung der Schicht nach der Polymerisation werden die nicht ausreichend polymerisierten Schichten ebenfalls entfernt. Die Reliefelemente sind somit kleiner als sie eigentlich sein sollen und weisen abgerundete Ecken auf. Dieser Effekt ist beispielsweise anschaulich in EP-A 2 128 702, Seite 15, Figur 1 dargestellt.

Grundsätzlich sollte der störende Einfluss von Sauerstoff bei der Belichtung von Flexodruckelementen ausgeschaltet werden, damit die vorgesehenen Reliefelemente bis zur Oberfläche vollständig polymerisiert werden und somit feinere Details auf der Platte abgebildet werden können und in Vollflächen sehr feine Strukturen abgebildet werden können. Dies dient vor allem zur Verbesserung der Farbübertragung und des Farbliegeverhaltens.

Es ist daher vorgeschlagen worden, die fotopolymerisierbare Schicht während der Hauptbelichtung vor Sauerstoff zu schützen. Es ist prinzipiell möglich, unter Schutzgas oder unter Verwendung eines Vakuumrahmens zu belichten, aber diese Vorgehensweise ist mit zusätzlichem apparativem Aufwand verbunden und wird daher üblicherweise vermieden.

Weiterhin ist vorgeschlagen worden, die fotopolymerisierbare Schicht in Flexodruckelementen durch zusätzliche Barriereschichten vor Luftsauerstoff zu schützen. Solche Barriereschichten sollen die Diffusion von Sauerstoff in die fotopolymerisierbare Schicht verhindern oder zumindest minimieren.

US 5,262,275 offenbart Flexodruckelemente zur Herstellung von Flexodruckformen, welche einen Träger, eine fotopolymerisierbare Schicht, eine darauf aufgebrachte Barriereschicht und eine darauf aufgebrachte laserablatierbare Maskenschicht umfassen.

Die Barriereschicht soll einerseits die Migration von Komponenten, beispielsweise von Monomeren, aus der fotopolymerisierbaren Schicht in die laserablatierbare Schicht verhindern, und andererseits die fotopolymerisierbare Schicht vor atmosphärischem Sauerstoff während der Belichtung des Flexodruckelements schützen. Es werden sowohl fotopolymeriserbare als auch nicht fotopolymerisierbare Barriereschichten vorgeschlagen. Als Materialien für nicht fotopolymerisierbare Barriereschichten werden sowohl wasserlösliche als auch in organischen Lösungsmitteln lösliche Bindemittel vorgeschlagen, nämlich Polyamide, Polyvinylalkohol, Hydroxyalkylcellulose, Ethylen-Vinylacetat-Copolymere, amphotere Interpolymere und Kombinationen davon. Die Dicke der Barriereschicht beträgt in der Regel 0,25 µm bis 76 µm, bevorzugt 0,38 bis 64 µm.

WO 2012/145111 offenbart fotopolymerisierbare Flexodruckelemente zur Herstellung von Flexodruckformen, welche einen Träger, eine fotopolymerisierbare Schicht, eine darauf aufgebrachte Barriereschicht und eine darauf aufgebrachte laserablatierbare Schicht umfassen. Die Barriereschicht weist einen Diffusionskoeffizienten für O₂ von weniger als 6,9*10⁻⁹ m²/s und eine optische Transparenz von mindestens 50 %, bevorzugt mindestens 75 % auf. Die Schichtdicke der Barriereschicht beträgt 1 bis 100 µm, bevorzugt 1 bis 20 µm. Als Materialien für die Barriereschicht werden sowohl wasserlösliche als auch in organischen Lösungsmitteln lösliche Bindemittel vorgeschlagen, nämlich Polyamide, Polyvinylalkohol, Hydroxyalkylcellulose, Polyvinylpyrrolidon, Ethylen-Vinylacetat-Copolymere, amphotere Interpolymere, Celluloseacetatbutyrat, Alkylcellullose, Butyral, cyclische Kautschuke oder Kombinationen davon.

US 2012/0164584 offenbart ein Verfahren zur Herstellung von Flexodruckplatten unter Verwendung eines digital bebilderbaren Flexodruckelements, welche eine laserablatierbare Schicht aufweist. Nach dem Einschreiben einer Maske in die laserablatierbare Schicht wird eine Barriereschicht auf die Oberseite des Flexodruckelements aufgebracht, d.h. sie bedeckt sowohl die freigelegten Stellen der fotopolymerisierbaren Schicht sowie die noch vorhandenen Bereiche der laserablatierbare Schicht selbst. Anschließend wird mit UV-Licht belichtet. Als Materialien für die Barriereschicht werden sowohl wasserlösliche als auch in organischen Lösungsmitteln lösliche Bindemittel vorgeschlagen, nämlich Polyamide, Polyvinylalkohol, Hydroxyalkylcellulose, Polyvinylpyrrolidon, Ethylen-Vinylacetat-Copolymere, amphotere Interpolymere, Celluloseacetatbutyrat, Alkylcellullose, Butyral, cyclische Kautschuke oder Kombinationen davon. Weiterhin kann es sich um Öle handeln. Die Dicke der Barriereschicht beträgt 1 bis 100 µm, bevorzugt 1 bis 20 µm. Das Aufbringen der Barriereschicht bedeutet einen zusätzlichen Verfahrensschritt zwischen Bebildern und Belichten und somit zusätzlichen Aufwand.

WO 2005/101130 (Kodak) offenbart einen mehrschichtigen Maskenfilm zur Herstellung von Flexodruckformen. Der Maskenfilm umfasst einen Träger, eine IR-empfindliche Schicht, beispielsweise eine IR-ablative Schicht sowie optional weitere Schichten, beispielsweise eine Barriereschicht oder eine Release-Schicht. Der Maskenfilm kann mit einem Laser bebildert werden, wird anschließend auf ein fotopolymerisierbares Flexodruckelement auflaminiert, wobei die Trägerschicht des Maskenfilms die oberste Schicht bildet. Der Verbund aus Maskenschicht wird anschließend vollflächig belichtet, wobei die Belichtung durch die Trägerschicht erfolgen kann oder die Trägerschicht vor dem Belichten abgezogen werden kann. Nach dem Belichten kann die Trägerfolie (sofern nicht schon entfernt) mit oder auch ohne die eigentliche Maskenschicht abgezogen werden, und das belichtete Flexodruckelement kann in üblicher Art und Weise entwickelt werden.

Laminierverfahren wie das nachträgliche Aufbringen einer Sauerstoff sperrenden Folie oder das nachtägliche Aufbringen eines zuvor belichteten Maskenfilms sind nicht zu empfehlen, da bei jeder Laminierung z.B. durch Einschluss von Staubpartikeln oder Einschluss von Luft Fehlstellen entstehen können. Jede kleinste Fehlstelle macht das Flexoklischee aber unbrauchbar. Ferner ist das Laminieren bzw. das nachträgliche Aufbringen von Barriereschichten ein zusätzlicher Arbeitsschritt im Zuge der Verarbeitung des Flexodruckelements und von daher beim Anwender äußerst unerwünscht.

Weiterhin sind im Stand der Technik spezielle Belichtungsverfahren bekannt, beispielsweise aus WO 2012/010459 oder WO 2008/135865, bei denen die Belichtung der Flexodruckelemente mittels intensiver UVA-LED Strahlung erfolgt. Durch die hohe Energie der Belichtung und die dementsprechend schnelle Polymerisation wird der Einfluss störenden Sauerstoffs minimiert, und es können auch feine Oberflächenstrukturen auf den Flexodruckklischees abgebildet werden. Die Belichtungsgeräte sind aber erheblich teurer als marktübliche UVA-Röhrenbelichter. Des Weiteren sind zur Abbildung feiner Details relativ lange Belichtungszeiten notwendig, was die Akzeptanz dieser Technik im Markt weiter erschwert.

Ein Flexodruckelement, welches zwischen der laserablatierbaren Maskenschicht und der fotopolymerisierbaren Reliefschicht eine Barriereschicht umfasst, die den Eintritt von Luftsauerstoff in die fotopolymersierbare Schicht während der UV-Belichtung verhindert oder zumindest deutlich reduziert, ist somit trotz anderer Vorschläge nach wie vor ein interessanter Lösungsvorschlag.

Dennoch sind auch mit der Verwendung von Barriereschichten eine Reihe bislang nicht gelöster Probleme verbunden.

Es gibt zwar eine Reihe von Materialien, deren Permeabilität für molekularen Sauerstoff gering und deren Verwendung als Barriereschicht in Flexodruckelementen daher grundsätzlich denkbar ist, aber die Verarbeitung derartiger Flexodruckelemente in marktüblichen Verarbeitungsgeräten unter Verwendung marktüblicher Auswaschmittel stellt eine Reihe zusätzlicher Anforderungen an die Barriereschicht, so dass es nicht möglich ist, beliebige Materialien mit niedriger Permeabilität für molekularen Sauerstoff zu verwenden.

Die fotopolymerisierbaren Schichten üblicher Flexodruckelemente umfassen im Wesentlichen unpolare Bindemittel, wie beispielsweise Styrol-Butadien-Styrol-Blockcopolymere oder Styrol-Isopren-Styrol-Blockcopolymere sowie weitere unpolare Komponenten.

Die laserablatierbare Maskenschicht umfasst üblicherweise ebenfalls in organischen Lösemitteln lösliche, elastomere Bindemittel wie beispielsweise weichelastische Polyamide.

Typische Flexoauswaschmittel enthalten daher eine unpolare Hauptkomponente (Kohlenwasserstofflösungsmittel) zum Lösen der photopolymerisierbaren Schicht und einen Alkohol mittlerer Polarität (z.B. Benzylalkohol) zum Lösen der laserablatierbaren Maskenschicht. Polare Bindemittel können in einem solchen Flexoauswaschmittel aber nicht gelöst werden.

Materialien mit einer niedrigen Permeabilität für Sauerstoff sind häufig polare Substanzen, die dementsprechend nur in Wasser oder in Wasser/Alkoholmischungen löslich sind.

Die Kombination einer unpolaren laserablatierbaren Schicht und einer unpolaren fotopolymeriserbaren Schicht mit einer polaren Barriereschicht ist daher beim Auswaschen belichteter Flexodruckelemente äußerst unerwünscht, denn polare Barriereschichten können in den marktüblichen, weitgehend unpolaren Flexoauswaschmitteln nicht gelöst werden.

Umfasst ein Flexodruckelement eine polare Barriereschicht, dann muss das Auswaschen in zwei oder sogar drei Schritten durchgeführt werden. Verwendet man beispielsweise eine laserablatierbare Maskenschicht aus einem weichelastischen Polyamid und Ruß gemäß Stand der Technik und eine polare Barriereschicht, dann muss zum Auswaschen zunächst Benzylalkohol (zum Lösen der Maskenschicht), anschließend Wasser (zum Lösen der Barriereschicht) und schließlich ein Kohlenwasserstofflösungsmittel (zum Lösen der fotopolymerisierbaren Schicht) eingesetzt werden. Dies ist äußerst unwirtschaftlich und wird vom Markt nicht akzeptiert.

Auch aus den üblichen Techniken zur Bebilderung von Flexodruckelementen mit laserablatierbaren Maskenschichten ergaben sich Anforderungen an die Barriereschicht.

Bei der Verarbeitung eines Flexodruckelements mit der üblichen Schichtfolge Trägerfolie - fotopolymerisierbare Schicht - Barriereschicht - laserablatierbare Schicht - Deckfolie/Schutzfolie wird zunächst die Deckfolie/Schutzfolie entfernt. Diese sollte sich leicht von der laserablatierbaren Maskenschicht abziehen lassen, wobei die Haftung der laserablatierbaren Maskenschicht zur Barriereschicht und die Haftung der Barriereschicht zur fotopolymerisierbaren Schicht so gut sein muss, dass beide vollständig auf der photopolymerisierbaren Schicht verbleiben.

Handelsübliche Laserapparaturen zur Bebilderung umfassen eine rotierende Trommel, auf die das Flexodruckelement - mit der laserablatierbaren Schicht nach außen - aufgespannt werden muss. Das Aufbringen auf die Trommel erfordert das Biegen des Flexodruckelements entsprechend der Krümmung der Trommel und zwangsläufig wird hierbei die Oberfläche des Flexodruckelements gedehnt. Bei diesem Vorgang darf weder die laserablatierbare Maskenschicht noch die darunter liegende Barriereschicht reißen.

Nach der Bebilderung wird das Flexodruckelement von der Lasertrommel demontiert und in einer Belichtungseinheit mit UV-Licht belichtet. Bei den handelsüblichen UV-Belichtern erfolgt dies in flachem Zustand des Flexodruckelements, d.h. das Flexodruckelement muss zum Auswaschen wieder gerade gebogen werden. Weder der Rest der Maskenschicht noch die Barriereschicht dürfen sich hierbei runzeln oder strukturieren, da sich diese Strukturen bei der folgenden UV-Belichtung in die photopolymerisierbare Schicht abbilden würden. Polare Materialien mit einer geringen Permeabilität für molekularen Sauerstoff sind aber in der Regel äußerst spröde. Barriereschichten aus derartigen, spröden Materialien reißen, wenn sie bei der Montage auf die Lasertrommel gedehnt werden, und zeigen nach der Demontage von der Lasertrommel unerwünschte Wellenstrukturen.

Eine Aufgabe der Erfindung war es, Flexodruckelemente mit einer Barriereschicht für Sauerstoff bereit zu stellen, welche ohne Beschädigung auf die Trommel einer Laserapparatur zur Bebilderung montiert und wieder demontiert werden können, und die nach dem Belichten in handelsüblichen, weitgehend unpolaren Flexoauswaschmitteln auswaschbar sind.

Überraschenderweise wurde gefunden, dass Flexodruckelemente mit polaren, ultradünnen Barriereschichten diese Anforderungen erfüllen. Die Aufgabe wird durch die in den Ansprüchen beschriebene technische Lehre gelöst. Die Erfindung ist gemäß den beigefügten Ansprüchen.

Dementsprechend wurde ein digital bebilderbares, fotopolymerisierbares, unter Verwendung von Kohlenwasserstoffe umfassenden Auswaschmitteln entwickelbares Flexodruckelement zur Herstellung von Flexodruckplatten gefunden, welches in der genannten Reihenfolge übereinander angeordnet mindestens
(A) eine dimensionsstabile Trägerfolie mit einer Dicke von 50 µm bis 300 µm,
(B) eine in organischen Lösemitteln lösliche oder dispergierbare, fotopolymerisierbare, reliefbildende Schicht einer Schichtdicke von 300 µm bis 6000 µm, umfassend mindestens ein elastomeres Bindemittel, ein ethylenisch ungesättigtes Monomer (als Baustein) sowie einen Fotoinitiator oder ein Fotoinitiatorsystem,
(C) eine transparente Barriereschicht für Sauerstoff,
(D) eine in organischen Lösemitteln lösliche oder dispergierbare, laserablatierbare Maskenschicht mit einer Schichtdicke von 1 µm bis 4 µm, umfassend mindestens ein elastisches Bindemittel und UV/VIS-Licht absorbierende Materialien, wobei die Schichtdicke und/oder die Menge der lichtabsorbierenden Materialien so bemessen werden, dass die optische Dichte der Schicht für UV/VIS-Strahlung 2 bis 4 beträgt, sowie
(E) eine abziehbare Deckfolie,
umfasst und wobei
- die Barriereschicht (C) polar ist und in Wasser und/oder mindestens 50 Gew. % Wasser umfassenden Wasser-Alkohol Gemischen löslich ist, und
- die Barriereschicht (C) eine Schichtdicke von 10 nm bis 999 nm aufweist.

Weiterhin wurde ein Verfahren zur Herstellung von Flexodruckplatten gefunden, bei dem man als Ausgangsmaterial ein derartiges Flexodruckelement einsetzt, und welches mindestens die folgenden Verfahrensschritte umfasst:
(1) Abziehen der Deckfolie (E),
(2) Einschreiben einer Maske in die laserablatierbare Maskenschicht (D) mithilfe eines IR-Lasers,
(3) Belichten des bebilderten Flexodruckelements mit UV- bzw. UV-VIS-Strahlung durch die gebildete Maske hindurch,
(4) Entfernen der Reste der laserablatierbaren Maskenschicht (E), der gegebenenfalls vorhandenen Schutzschicht (X) und der Barriereschicht (C) sowie der nicht polymerisierten Anteile der reliefbildenden Schicht (B) unter Verwendung eines Auswaschmittels, welches mindestens 60 Gew. % Kohlenwasserstoffe umfasst,
(5) Trocknen der erhaltenen Flexodruckplatte, sowie
(6) Nachbehandeln mit UV-A und/oder UV-C-Licht.

Zu der Erfindung ist im Einzelnen das Folgende auszuführen:
Im Folgenden werden die Begriffe "Flexodruckplatte", "Flexodruckform" oder "Klischee" für eine bereits vernetzte, druckfertige Druckform verwendet. Der Begriff "Flexodruckelement" wird in üblicher Art und Weise für das fotopolymerisierbare Ausgangsmaterial verwendet, welches zur Herstellung von Flexodruckformen bzw. Flexodruckplatten eingesetzt wird.

Das erfindungsgemäße, digital bebilderbare Flexodruckelement ist so beschaffen, dass es nach dem bildmäßigen Belichten unter Verwendung von Auswaschmitteln umfassend einen oder mehrere Kohlenwasserstoffe entwickelbar ist.

### Trägerfolie (A)

Das erfindungsgemäße Flexodruckelement umfasst in prinzipiell bekannter Art und Weise eine dimensionsstabile Trägerfolie (A) mit einer Dicke von vorzugsweise 50 µm bis 300 µm. Bei dem Material der Trägerfolie kann es sich beispielweise um Stahl oder Aluminium oder um Kunststoffe wie beispielsweise Polyethylenterephalat, Polybutylenterephalat, Polyethylennaphthalat oder Polycarbonat handeln. Geeignet sind insbesondere PET-Folien mit einer Dicke von 100 bis 200 µm.

Die Trägerfolien können optional mit üblichen, haftvermittelnden Schichten behandelt sein.

### Reliefbildende Schicht (B)

Das Flexodruckelement umfasst weiterhin mindestens eine in organischen Lösemitteln lösliche oder dispergierbare, fotopolymerisierbare, reliefbildende Schicht (B) mit einer Schichtdicke von 300 µm bis 6000 µm, umfassend mindestens ein elastomeres Bindemittel, (mindestens) ein ethylenisch ungesättigtes Monomer sowie einen Fotoinitiator oder ein Fotoinitiatorsystem. Neben den genannten Komponenten können optional noch weitere Komponenten wie beispielsweise Weichmacher vorhanden sein. Bei den elastomeren Bindemitteln kann es sich beispielsweise um thermoplastischelastomere Blockcopolymere, beispielsweise Styrol-Butadien- oder Styrol-Isopren-Blockcopolymere handeln. In organischen Lösemitteln lösliche oder zumindest dispergierbare Zusammensetzungen für reliefbildende Schichten sind dem Fachmann prinzipiell bekannt. Er wählt je nach den gewünschten Eigenschaften der Flexodruckplatte eine geeignete Zusammensetzung.

Das erfindungsgemäße Flexodruckelement kann auch mehrere in organischen Lösemitteln lösliche oder dispergierbare, fotopolymerisierbare, reliefbildende Schichten übereinander umfassen. Flexodruckelemente mit einem mehrschichtigen Aufbau der fotopolymerisierbaren, reliefbildenden Schicht sind dem Fachmann ebenfalls bekannt.

Bevorzugt handelt es sich bei der reliefbildenden Schicht (B) um eine in Kohlenwasserstoffen oder Kohlenwasserstoffe umfassenden organischen Lösemittelgemischen lösliche oder zumindest dispergierbare Schicht. Insbesondere handelt es sich bei der reliefbildenden Schicht um eine in mindestens 60 Gew. % Kohlenwasserstoffe, bevorzugt mindestens 75 Gew. % Kohlenwasserstoffe umfassenden organischen Lösemittelgemischen lösliche Schicht.

Die Polarität der organischen Lösemittel kann in prinzipiell bekannter Art und Weise durch den sogenannten Löslichkeitsparameter beschrieben werden (Löslichkeitsparameter nach Hansen, J. Appl. Polym. Sci, 5 (15), 339 (1961)). In einer bevorzugten Ausführungsform der Erfindung handelt er sich bei der reliefbildenden Schicht (B) um eine in organischen Lösemitteln bzw. Lösemittelgemischen mit einem Löslichkeitsparameter < 11 (cal/cm³)^{1/2}lösliche Schicht.

### Deckfolie (E)

Die abziehbare Deckfolie (E) ist die oberste Schicht des Flexodruckelements und dient unter anderem dem Schutz des Flexodruckelemements. Die Deckfolie wird vor der Verwendung des Flexodrucklelements zur Herstellung von Flexodruckplatten abgezogen. Als abziehbare Deckfolien (E) eignen sich insbesondere PET Folien mit mäßiger oder geringer Rauhigkeit. Typische Rz-Werte sollten unter 1 µm liegen. Beispielsweise kann eine Mylar^{®} A PET Folie eingesetzt werden.

### Laserablatierbare Maskenschicht (D)

Die laserablatierbare, in organischen Bindemitteln lösliche oder dispergierbare Maskenschicht (D), auch LAMS-Schicht genannt, umfasst mindestens ein elastisches Bindemittel, insbesondere weichelastische Bindemittel. Selbstverständlich können auch Gemische mehrerer verschiedener Bindemittel eingesetzt werden.

Die elastischen Bindemittel verleihen der laserablatierbaren Maskenschicht (D) eine ausreichende Flexibilität und Dehnung, so dass die Schicht beim Montieren auf die Trommel einer Laserapparatur nicht reißt oder runzelt. Außerdem sollte eine gute Haftung zu darunterliegenden Schichten gewährleistet sein.

Beispiele geeigneter Bindemittel umfassen weichelastische Polyamide. Derartige Polyamide umfassen als monomere Bausteine langkettige, bifunktionelle Fettsäuren, die dem Polyamid weichelastische Eigenschaften verleihen. Weiterhin können Polyesteramide, Cellulosederivate, Nitrocellulose, Ethylenvinylacetat-Copolymere, Polyacrylate oder Mischungen der genannten Polymere eingesetzt werden, sofern sie weichelastische Eigenschaften besitzen.

In einer bevorzugten Ausführungsform der Erfindung handelt es sich um Bindemittel, die in organischen Lösemitteln, insbesondere organischen Lösemitteln mittlerer Polarität löslich sind. Beispiele von Lösemitteln mittlerer Polarität umfassen insbesondere mono- oder mehrfunktionelle Alkohole mit C₄- bis C₁₂-Kohlenwasserstoffresten. Die Polarität der Lösemittel kann in prinzipiell bekannter Art und Weise durch den sogenannten Löslichkeitsparameter beschrieben werden (Löslichkeitsparameter nach Hansen, J. Appl. Polym. Sci, 5 (15),339 (1961)). Die genannten Alkohole haben Löslichkeitsparameter in einem Bereich von 9 bis 12 (cal/cm³)^{1/2}.

Bei Schichten mit derartigen Bindemitteln lassen sich die Reste der laserablatierbaren Maskenschicht nach Bebilderung und bildmäßiger Belichtung mit marktüblichen Flexoauswaschmitteln umfassend unpolare Kohlenwasserstoffe und mäßig polare Alkohole (z.B. Produkt nylosolv^{®} von Flint Group) lösen bzw. wegwaschen.

Als Bindemittel für die laserablatierbare Maskenschicht besonders gut geeignet ist Makromelt^{®} 6900 (Henkel AG), ein weichelastisches Polyamid.

Die laserablatierbare Maskenschicht (D) umfasst weiterhin UV/VIS-Licht absorbierende Materialien, wobei die Schichtdicke und/oder die Menge der lichtabsorbierenden Materialien so bemessen werden, dass die optische Dichte der Schicht für UV/VIS-Strahlung 2 bis 4 beträgt. Die hohe optische Dichte gewährleistet, dass die von der Maske bedeckten Bereiche der reliefbildenden Schicht im Zuge der vollflächigen Belichtung nicht polymerisieren.

Die optische Dichte ist die logarithmische Maßzahl für die Lichtdurchlässigkeit der Schicht in diesem Wellenlängenbereich. Bei der Messung der optischen Dichte wird daher kein Einzelwert der Lichtdurchlässigkeit bei einer bestimmten Wellenlänge ermittelt, sondern ein Mittelwert der Lichtdurchlässigkeiten in einem definierten Wellenlängenbereich. Üblicherweise erfolgt die Messung der optischen Dichte mittels kommerziell verfügbarer Densitometer (z.B. von x-rite), wobei der Wellenlängenbereich vor der Messung ausgewählt wird. Im Allgemeinen umfasst dieser Wellenlängenbereich den Bereich von 300 bis 400 nm.

Als lichtabsorbierendes Material eignet sich insbesondere feinteiliger Ruß. Ruß absorbiert auch sehr gut im IR-Bereich und gewährleistet somit bei der Bebilderung mittels IR-Laser gleichzeitig auch eine schnelle Bebilderung. Selbstverständlich kann die laserablatierbare Maskenschicht aber auch andere UV- oder IR- Absorber auf Pigmentbasis oder lösliche Farbstoffe enthalten. Ruß ist üblicherweise in einer Menge von 10 bis 50 Gew.-%, bezüglich der Summer aller Komponenten, enthalten.

Die Schichtdicke der Maskenschicht sollte einige wenige µm, bevorzugt 1 µm bis 4 µm betragen. Bei Schichtdicken unter 1 µm ist es schwierig, eine ausreichende optische Dichte zu erreichen. Bei Schichtdicken oberhalb von 3 µm ist die Laserempfindlichkeit des Elementes zu gering, so dass lange Laserzeiten zur Bebilderung notwendig sind.

Die Laserempfindlichkeit der Maskenschicht (gemessen als die Energie, die notwendig ist, um 1 cm² Schicht zu ablatieren) sollte zwischen 1 und 4 mJ/cm² liegen, optimal ist ein Wert von etwa 2 mJ/cm².

### Barriereschicht für Sauerstoff (C)

Das erfindungsgemäße Flexodruckelement umfasst weiterhin eine transparente Barriereschicht (C) für Sauerstoff, welche auf der fotopolymerisierbaren Schicht angeordnet ist.

Die Aufgabe der Barriereschicht (C) ist es, in prinzipiell bekannter Art und Weise die Nachdiffusion von Sauerstoff in die reliefbildende Schicht (B) im Zuge der vollflächigen Belichtung des Flexodruckelements zu verhindern. Bevorzugt sollte die Sauerstoffdurchlässigkeit der Barriereschicht kleiner als 100, bevorzugt kleiner als 10 (cm³ x 100 µm)/(m² x d x bar) sein.

Erfindungsgemäß handelt es sich bei der Barriereschicht um eine polare Schicht.

"Polar" heißt, dass die Barriereschicht in Wasser und/oder mindestens 50 Gew. %, bevorzugt mindestens 70 Gew. %, besonders bevorzugt mindestens 80 Gew. % und beispielsweise mindestens 90 Gew. % Wasser umfassenden Wasser-Alkohol-Gemischen löslich ist. Bei den Alkoholen in den besagten Alkohol-Wasser-Gemischen handelt es sich um mit Wasser mischbare, aliphatische Monoalkohole ausgewählt aus der Gruppe von Methanol, Ethanol, n-Propanol oder i-Propanol.

Prinzipiell kann für die Barriereschicht jedes polare Material eingesetzt werden, mit welchem sich eine geringe Sauerstoffdurchlässigkeit erreichen lässt, insbesondere die oben angegebenen Sauerstoffdurchlässigkeiten unterschreiten lassen.

In einer Ausführungsform der Erfindung handelt es sich bei den Materialien für die Barriereschicht um polymere Materialien. Beispiele geeigneter Polymere umfassen Polymere aus der Klasse der Polyvinylalkohole, teil- und hochverseifte Polyvinylcarboxylate, insbesondere teil-und hochverseifte Polyvinylacetate, Poly(ethylenoxide-vinylalcohol) Pfropfcopolymere, Poly(ethylen-vinylalkohol)-Copolymere, wasserlösliche Polyamide oder wasserlösliche Polyvinylpyrrolidone .

Bevorzugt handelt es sich bei dem Material der Barriereschicht um mindestens ein Material ausgewählt aus der Gruppe bestehend aus Polyvinylalkohol, teil- und hochverseiftem Polyvinylcarboxylat, insbesondere teil- und hochverseiftem Polyvinylacetat, Poly(ethylenoxid-vinylalkohol) Pfropfcopolymeren oder wasserlöslichen Poly(ethylen-vinylalkohol)-Copolymeren.

Polyvinylalkohole werden durch Polymerisation von Vinylcarboxylaten, insbesondere Vinylacetaten zum Polyvinylcarboxylaten, insbesondere Polyvinylacetaten, gefolgt von Hydrolyse der Vinylcarboxylateinheiten zu Vinylalkoholeinheiten hergestellt. Die erhaltenen Polymere werden in der Regel hinsichtlich ihres Verseifungsgrades charakterisiert. Bei "Polyvinylalkoholen" handelt es sich also nicht nur um Polymere, welche ausschließlich Vinylalkoholeinheiten umfassen, sondern auch um Copolymere aus Vinylcarboxylat-Einheiten und Vinylalkohol-Einheiten.

Als "teilverseift" im Sinne dieser Erfindung sollen Poly(vinylcarboxylat-vinylalkohol)copolymere, insbesondere Poly(vinylacetat-vinylalkohol)copolymere mit einem Gehalt an Vinylalkoholeinheiten von mindestens 50 mol % bezüglich aller Monomere bezeichnet werden.

Als "hochverseift" im Sinne dieser Erfindung sollen Poly(vinylcarboxylat-vinylalkohol)copolymere, insbesondere Poly(vinylacetat-vinylalkohol)copolymere mit einem Gehalt an Vinylalkoholeinheiten von mindestens 70 mol % bezüglich aller Monomere bezeichnet werden.

Als "Polyvinylakohole" im Sinne dieser Erfindung sollen Polyvinylalkohol-Homopolymere oder Poly(vinylcarboxylat-vinylalkohol)copolymere, insbesondere Poly(vinylacetat-vinylalkohol)copolymere mit einem Gehalt an Vinylalkoholeinheiten von mindestens 90 mol % bezüglich aller Monomere bezeichnet werden.

Besonders bevorzugt handelt es sich bei dem Material der Barriereschicht um Materialien ausgewählt aus der Gruppe bestehend aus hochverseiften Polyvinylcarboxylaten, Poylvinylalkoholen oder Ethylen-Vinylalkoholcopolymeren mit einem Anteil an Vinylalkoholeinheiten von über 70%, ganz besonders bevorzugt sind Polyvinylalkohole.

Neben den genannten polymeren Materialien können die Barriereschichten auch noch weitere Komponenten umfassen. Derartige Materialien können eingesetzt werden, um die Eigenschaften der Barriereschicht zu modifizieren. Bei zusätzlichen Komponenten kann es sich insbesondere um polare Weichmacher handeln. Beispiele derartiger Weichmacher umfassen Glykol, Glycerin oder Polyethylenglykole. Die Menge der Weichmacher wird vom Fachmann je nach den gewünschten Eigenschaften der Schicht bestimmt. Sie beträgt aber im Allgemeinen nicht mehr als 20 Gew.-% bezüglich der Menge aller Komponenten der Barriereschicht. Beispiele weiterer Komponenten umfassen Hilfsstoffe können zur Stabilisierung gegen unerwünschte Vernetzung. Diese verhindern, dass die Barriereschichten bei der Bestrahlung mit aktinischem Licht vernetzen und dadurch eventuell beim Auswaschen nicht mehr entfernt werden können. Bei derartigen Hilfsstoffen kann es sich beispielsweise um Xyligen-Kaliumsalze in einer Menge von 0,1 bis 5 Gew.-% in Kombination mit geringen Konzentrationen an Farbstoffen handeln.

In einer weiteren Ausführungsform der Erfindung handelt es sich bei der Barriereschicht (C) um anorganische, polare Schichten aus Metall- bzw. Nichtmetalloxiden. Die anorganischen Oxide können aus Lösung, Dispersion oder durch Sputtertechnik aufgetragen werden. Besonders gut geeignet sind Beschichtungen auf Basis von Siliciumoxiden, wie sie auch bei Sauerstoff sperrenden Verpackungsfolien eingesetzt werden.

Erfindungsgemäß weist die Barriereschicht (C) eine Schichtdicke von 10 nm bis 999 nm, beispielsweise 100 nm bis 999 nm, bevorzugt 100 bis 400 nm und besonders bevorzugt 100 bis 249 nm auf.

Die minimale Schichtdicke der Barriereschicht hängt auch vom Material der Barriereschicht ab. Für Schichten aus Metall- oder Nichtmetalloxiden, die im Sputterverfahren aufgebracht werden, kann bereits eine Schicht von 10 nm ausreichend sein. Für Barriereschichten aus polymeren Bindemitteln empfiehlt es sich, eine Schichtdicke von mindestens 100 nm vorzusehen.

Da die beschriebenen Materialien der Barriereschicht (C) polar sind, sind sie -als solche- in handelsüblichen unpolaren, organischen Auswaschmitteln für Flexodruckplatten nicht löslich. Handelsübliche organische Lösemittel umfassen in der Regel mindestens 60 Gew. % Kohlenwasserstoffe.

Ferner sind die beschriebenen Materialien im Vergleich zur photopolymerisierbaren Schicht (B) relativ hart und spröde. Aufgebracht in größeren Schichtdicken von nur wenigen µm reißen sie bei der Montage auf die Lasertrommel.

Umso überraschender war der Befund, dass die erfindungsgemäßen Flexodruckelemente nach der bildmäßigen Belichtung trotz der polaren Barriereschicht (C) problemlos unter Verwendung von Kohlenwasserstoffe umfassenden Auswaschmitteln ausgewaschen werden konnten. Auch die ultradünne, polare Barriereschicht wird beim Auswaschen in den besagten unpolaren Auswaschmitteln entfernt.

Ebenso überraschend können die erfindungsgemäßen Flexodruckelemente trotz der relativ harten und spröden Materialien der Barriereschicht bei der Montage auf die Lasertrommel gedehnt werden, ohne zu reißen.

Die Auswertung der unter Verwendung der erfindungsgemäßen Flexodruckelemente erhaltenen Flexodruckplatten belegt ferner, dass die ultradünnen Barriereschichten (C) ausreichend gegen Sauerstoff sperren und sich Flexodruckplatten mit höchster Detailzeichnung und feinsten Oberflächenstrukturen erhalten lassen.

### Schutzschicht (X)

Bei der Bebilderung mittels IR-Laser wird die Maskenschicht an der Stelle, an der sie vom Laserstrahl getroffen wird, sehr stark erhitzt, so dass sich die Komponenten der Schicht zersetzen. Hierbei können in der Maskenschicht lokal sehr hohe Temperaturen, unter Umständen von einigen tausend Grad Celsius, erzeugt werden. Diese Temperaturen können unter Umständen auch die sehr dünne Barriereschicht (C) angreifen. Dies ist unerwünscht, denn dadurch ist die darunter liegende reliefbildende Schicht (B) nicht mehr vor dem Einfluss von Sauerstoff geschützt.

Optional umfasst das erfindungsgemäße Flexodruckelement daher weiterhin eine zwischen den Schichten (C) und (D) angeordnete, transparente Schicht (X), deren Aufgabe es ist, die unter der Schicht (X) angeordnete, ultradünne Barriereschicht (C) vor Beschädigungen durch Laserstrahlung im Zuge der Bebilderung zu schützen.

Die Schutzschicht (X) ist transparent oder zumindest weitgehend transparent für UV/VIS-Strahlung, so dass die vollflächige Belichtung der reliefbildenden Schicht durch die Schicht (X) nicht gestört wird. Sowohl die Barriereschicht (C) als auch die Schutzschicht (X) sollten eine Transparenz von mindestens 80 % im UV/VIS-Bereich aufweisen.

Die Schutzschicht (X) umfasst mindestens ein elastisches, insbesondere ein weichelastisches, polymeres Bindemittel. Dieses Bindemittel ist verschieden von gegebenenfalls in der Barriereschicht (C) verwendeten Bindemitteln. Selbstverständlich können auch Gemische verschiedener Bindemittel verwendet werden.

In einer bevorzugten Ausführungsform der Erfindung handelt es sich um Bindemittel, welche in organischen Lösemitteln, insbesondere organischen Lösemitteln mittlerer Polarität -wie oben definiert- löslich sind.

Bei dem Bindemittel kann es sich beispielsweise um weichelastische Polyamide handeln (beispielsweise Makromelt^{®} 6900 (Henkel)), die gleichzeitig auch Bindemittel der laserablatierbaren Maskenschicht (D) sein können.

Die Dicke der transparenten Schutzschicht (X) sollte zwischen 0,1 µm und 4 µm, bevorzugt 0,1 µm und 2,5 µm liegen. Wird die Schichtdicke zu gering gewählt, kann die darunter liegende Barriereschicht unter Umständen angegriffen werden. Ist die Schichtdicke zu hoch, kann es zu Streueffekten kommen, die die Abbildung feiner Negativelemente der Flexodruckplatten beeinträchtigt.

### Herstellung der Flexodruckelemente

Die Herstellung der erfindungsgemäßen Flexodruckelemente erfolgt in prinzipiell bekannter Art und Weise, indem man die Komponenten der fotopolymerisierbaren Schicht in einem Extruder aufschmilzt, mischt und die Schmelze des photopolymerisierbaren Materials durch eine Breitschlitzdüse in den Spalt eines Kalanders austrägt. Über die eine Kalanderwalze läuft eine Trägerfolie, die optional mit weiteren Schichten, wie beispielsweise einer Haftschicht beschichtet sein kann, und über die andere Kalanderwalze läuft das vorgefertigte Deckelement ein.

Zur Herstellung des Deckelementes wird die Deckfolie (F) zunächst mit der laserablatierbaren Maskenschicht (D) beschichtet und dann mit der Barriereschicht (C) überschichtet. Sofern das Flexodruckelement optional eine Schutzschicht (X) umfassen soll, wird die Deckfolie (F) zunächst mit der laserablatierbaren Maskenschicht (D) beschichtet, anschließend mit der Schutzschicht (X) und schließlich mit der Barriereschicht (C) überschichtet.

Das Aufbringen der einzelnen Schichten kann erfolgen, indem man die Komponenten der Schichten in geeigneten Lösemitteln bzw. Lösemittelmischungen löst, nacheinander aufgießt und das Lösemittel jeweils verdampfen lässt. Vor Auftrag der jeweils nächsten Schicht kann es erforderlich sein, die zu beschichtende Oberfläche mittels Coronavorbehandlung aufzurauen, um eine verbesserte Schichtanbindung zu erreichen.

Die für die Herstellung von Gießlösungen zu verwendenden Lösemittel richten sich nach der Natur der Schicht. Die laserablatierbare Maskenschicht (D) ist in organischen Lösemitteln, bevorzugt den definierten organischen Lösemitteln mittlerer Polarität löslich, und dementsprechend können derartige Lösemittel zum Lösen der Komponenten der Gießlösung verwendet werden. Eine optional vorhandene Schutzschicht (X) kann analog aufgebracht werden.

Die polaren Barriereschichten können aus den beschriebenen Wasser-Alkohol-Mischungen, bevorzugt Wasser aufgebracht werden. Dies ist vorteilhaft, da dadurch die in organischen Lösungsmitteln lösliche Maskenschicht (D) sowie eine optional vorhandene Schutzschicht (X) nicht angegriffen werden.

Gießtechniken zum Aufbringen von Schichten sind dem Fachmann bekannt. Die Schichtdicke der aufzubringenden Schichten kann in prinzipiell bekannter Art und Weise durch Verdünnung der Gießlösung verringert werden. Zur Verbesserung der Beschichtungsqualität kann es erforderlich sein, der Beschichtungslösung oberflächenaktive Substanzen oder Verlaufshilfsmittel zuzusetzen.

Barriereschichten (C) aus Metall bzw. Nichtmetalloxiden, beispielsweise SiOₓ-Schichten können auch mittels Sputtertechnik aufgebracht werden. Sputtertechniken zum Beschichten sind dem Fachmann ebenfalls bekannt. Sputtertechniken beeinträchtigen nicht die Beschichtungsqualität der zuvor aufgebrachten Schichten.

Bei der Sputtertechnik kann die Schichtdicke in prinzipiell bekannter Art und Weise durch Erhöhung der Fahrgeschwindigkeit bei konstanter Sputterdosis (Menge/Fläche/Zeiteinheit) reduziert werden. Dazu wird festes SiO₂ (in der Regel Sand) mit einem Elektronenstrahl im Hochvakuum beschossen, wodurch es sublimiert und im gasförmigen Zustand aufgrund der unterschiedlichen Dichten und Temperaturen nach oben diffundiert. Am zu beschichtenden Substrat kondensiert das SiOₓ-Gas wieder und bildet eine dünne Schicht SiOₓ auf dem Substrat aus, die in den meisten Fällen sehr gut haftet.

Die Gleichmäßigkeit des Auftrages der ultradünnen Barriereschicht (C) kann mit dem Auftreten von Newtonschen Ringen kontrolliert werden, da die Lichtwellenlänge im Bereich der Schichtdicke der Barriereschicht liegt. Die Schichtdicke wird dabei bei den hier behandelten sehr dünnen Schichten über ein optisches Verfahren, die spektrale Reflektion, bestimmt. Dabei wird durch die Reflektion von Licht unterschiedlicher Wellenlängen an der Ober- und Unterseite der Schicht die Dicke bestimmt.

Das beschichtete Deckelement wird aufgerollt und bei der nachfolgenden Extrusion über eine der Kalanderwalzen eingefahren und so haftfest mit der photopolymerisierbaren Schicht verbunden.

Alternativ können Teile des Deckelementes auch in mehreren Schritten auflaminiert werden. Beispielsweise kann ein Deckelement aus einer ultradünnen Barriereschicht (C) auf einer temporären Hilfsfolie über die Kalanderwalzen eingefahren und mit der photopolymerisierbaren Schicht verbunden werden. Die Hilfsfolie wird anschließend abgezogen. In einem zweiten Laminierschritt wird dann die laserablatierbare Maskenschicht mit der eigentlichen Deckfolie aufkaschiert. Zur Verbesserung der Haftung der Schichten untereinander kann es erforderlich sein, das hergestellte Flexodruckelement mit einer geringen Dosis von Elektronenstrahlen zu behandeln.

### Verwendung der Flexodruckelemente zur Herstellung von Flexodruckplatten

Das erfindungsgemäße Verfahren zur Herstellung von Flexodruckplatten unter Verwendung der beschriebenen, digital bebilderbaren Flexodruckelemente umfasst vorzugsweise die Verfahrensschritte (1) bis (6). Das Verfahren kann optional noch weitere Verfahrensschritte umfassen.

In Verfahrensschritt (1) wird in prinzipiell bekannter Art und Weise die Deckfolie (E) vom Flexodruckelement entfernt.

In Verfahrensschritt (2) wird in prinzipiell bekannter Art und Weise eine Maske in die laserablatierbare Maskenschicht (D) mithilfe eines IR-Lasers eingeschrieben. Laserapparaturen zum Einschreiben von Masken sind dem Fachmann bekannt und sind kommerziell erhältlich. Prinzipiell können alle marktüblichen Laser (überwiegend Außentrommellaser) verwendet werden.

In einer Ausführungsform der Erfindung kann man zur Ausführung von Verfahrensschritt (2) eine Laserapparatur umfassend eine rotierbare Trommel einsetzen. Das Flexodruckelement wird zum Bebildern -mit der Trägerfolie zur Trommel gerichtet- auf die Trommel montiert. Es versteht sich von selbst, dass das Flexodruckelement hierbei gebogen wird und sich die Barriereschicht dementsprechend etwas dehnt. Die erfindungsgemäßen Flexodruckelemente können trotz der relativ harten und spröden Materialien der Barriereschicht bei der Montage auf die Lasertrommel gedehnt werden, ohne zu reißen.

In Verfahrensschritt (3) wird das bebilderte Flexodruckelement mit UV- bzw. UV-VIS-Strahlung durch die gebildete Maske hindurch in prinzipiell bekannter Art und Weise belichtet. Hierbei polymerisiert die fotopolymerisierbare Schicht in den von der Maske nicht mehr abgedeckten Bereichen, während in den abgedeckten Bereichen keine Polymerisation erfolgt. Die fotopolymerisierbare Schicht wird während der Belichtung durch die Barriereschicht (C) vor dem Einfluss von nachdiffundierendem Sauerstoff geschützt.
Apparaturen zum Belichten von Flexodruckplatten sind dem Fachmann prinzipiell bekannt. Die Belichtung der Flexodruckelemente kann mit marktüblichen Röhrenbelichtern erfolgen. UV-LED Hochenergieleisten müssen nicht eingesetzt werden, können aber jederzeit verwendet werden. In einer Ausführungsform der Erfindung wird für Verfahrensschritt (3) ein Flachbettbelichter verwendet. Hierzu muss das Flexodruckelement -wenn es in Verfahrensschritt (2) mittels eines Trommellasers belichtet wurde- wieder flach gebogen werden, was mit den erfindungsgemäßen Flexodruckelementen problemlos möglich ist.

In Verfahrensschritt (4) werden die Reste der laserablatierbaren Maskenschicht (E), die gegebenenfalls vorhandene Schutzschicht (X) und die Barriereschicht (C) sowie die nicht polymerisierten Anteile der reliefbildenden Schicht (B) unter Verwendung eines Auswaschmittels, welches mindestens 60 Gew. % Kohlenwasserstoffe umfasst, entfernt. Dies kann unter Verwendung üblicher Auswaschgeräte, insbesondere unter Verwendung von Flachbett-Auswaschgeräten erfolgen. Bei den Kohlenwasserstoffen kann es sich insbesondere um hochsiedende aliphatische, cycloaliphatische oder aromatische Kohlenwasserstofffraktionen, insbesondere solche mit einem Siedebereich von 160 bis 220°C handeln.

In einer bevorzugten Ausführungsform der Erfindung umfasst das Auswaschmittel 60 bis 95 Gew. % Kohlenwasserstoffe sowie 5 bis 40 Gew. % Alkohole. Es versteht sich von selbst, dass es sich bei den Alkoholen um solche handelt, die mit den Kohlenwasserstoffen mischbar sind. Es werden in der Regel Monoalkohole mit mindestens 4 Kohlenstoffatomen, bevorzugt mindestens 5 Kohlenstoffatomen, beispielsweise 5 bis 10 Kohlenstoffatomen eingesetzt. Beispiele umfassen n-Pentanol, Cyclohexanol, Benzylalkohol, Heptylalkohole oder 2-Ethylhexanol.

Beispielsweise können die in EP-A 332 070 beschriebenen Flexoauswaschmittel verwendet werden. Geeignete Auswaschmittel sind kommerziell erhältlich. Die meisten im Markt verwendeten Auswaschmittel enthalten unpolare Kohlenwasserstoffe als Hauptkomponente sowie Alkohole mittlerer Polarität in einer Menge von 10 bis 30% Gew. %. Beispiele kommerzieller Auswaschmittel umfassen Mischungen enthaltend ca. 40 Gew. % hochsiedende Kohlenwasserstofflösemittel, ca. 40 Gew. % Decalin und ca. 20 Gew. % n-Pentanol, Mischungen enthaltend ca. 50% Gew. % hochsiedende Kohlenwasserstofflösemittel, ca. 20 Gew. % Diisopropylbenzol und ca. 30 Gew. % Cyclohexanol, Mischungen enthaltend ca. 56 Gew. % Decalin, ca. 27 Gew. % aliphatisches Kohlenwasserstofflösemittel, ca. 12 Gew. % Benzylalkohol und ca. 2 Gew. % Ethylhexanol sowie Mischungen enthaltend ca. 70 Gew. % aromatische Kohlenwasserstoffe und ca. 30 Gew. % Heptylalkohole.

Überraschenderweise wird auch die polare, ultradünne Barriereschicht (C) bei Verwendung der beschriebenen, unpolaren Auswaschmittel vollständig entfernt.

In Verfahrensschritt (5) wird die erhaltene Flexodruckplatte in prinzipiell bekannter Art und Weise getrocknet und in Verfahrensschritt (6) in prinzipiell bekannter Art und Weise mit UV-A und/oder UV-C-Licht nachbehandelt.

Es ist selbstverständlich möglich, die erfindungsgemäßen Flexodruckelemente auch nach anderen Verfahren zu Flexodruckplatten zu verarbeiten. Selbstverständlich ist auch eine mehrstufige Entwicklung unter Verwendung unterschiedlicher Lösemittel bzw. Lösemittelmischungen möglich. Weiterhin ist es möglich, das belichtete Flexodruckelement nicht unter Verwendung von Auswaschmitteln, sondern thermisch zu entwickeln.

Die Erfindung wird in den folgenden Beispielen näher erläutert.

### Vergleichsbeispiel 1:

### Digital bebilderbares Flexodruckelement ohne Barriereschicht

Es wurde ein handelsübliche, digital bebilderbares Flexodruckelement mit einer organisch entwickelbaren fotopolymerisierbaren Schicht (Typ nyloflex^{®} ACE 114 D) verwendet. Die Dicke der Maskenschicht beträgt 3,2 µm, die optische Dicht der Maskenschicht beträgt 3,7.

Das Flexodruckelement wurde zunächst 10 Sekunden rückseitig vorbelichtet. Die Deckfolie wurde abgezogen. Nach der Vorbelichtung wurde in die Maskenschicht des Flexodruckelementes mithilfe eines IR-Lasers ein Testmotiv eingeschrieben. Die Nichtbildbereiche bleiben hierbei aufgrund der noch verbleibenden Maskenschicht UVundurchlässig, während durch die Entfernung der Maske in den Bildbereichen die Härtung der fotopolymerisierbaren Reliefschicht mittels aktinischer Strahlung ermöglicht wird. Die Bebilderung der digitalen Maske wurde mit Hilfe eines Ablationslasersystems "nano" der Firma Flexolaser GmbH vorgenommen, wobei die verwendete Maskenauflösung 2540 dpi betrug.

Die so vorbereitete Platte wurde anschließend für 14 Minuten mit aktinischer Strahlung belichtet (nyloflex^{®} F III Belichter, Flint Group) und anschließend entwickelt.

Die lösemittelbasierte Entwicklung der bildmäßig belichteten Flexodruckplatten wurde bei der jeweils angegebenen Auswaschgeschwindigkeit und mit der für den jeweiligen Produkttyp empfohlenen Bürstenstellung mit Hilfe eines nyloflex^{®} F III-Auswaschgeräts durchgeführt. Als Auswaschmittel wurde ein handelsübliches Auswaschmittel aus ca. 70 Gew. % Kohlenwasserstoffen und ca. 30 Gew. % eines Alkohols (nylosolv^{®} A) eingesetzt.

Nach dem Auswaschprozess wurden die noch lösemittelhaltigen Platten laut den produktspezifischen Empfehlungen 90 Minuten bei 60-65°C getrocknet und anschließend in der Nachbelichtungseinheit eines nyloflex^{®} F III-Belichters mit UVA- und UVC-Licht nachbelichtet. Die Nachbelichtung dient einerseits dazu, noch reaktive Restmengen an Monomer und Fotoinitiator umzusetzen, andererseits wird die Plattenoberfläche hierdurch klebfreier.

Die Auswertung des Klischees ergab, dass in der Regel hauptsächlich abgerundete Rasterpunkte beobachtet werden können. Niedrige Rastertonwerte können gar nicht mehr auf der Platte abgebildet werden. Bei einer Rasterweite von 60 L/cm beträgt der kleinste abgebildete Rastertonwert 7%.

### Vergleichsbeispiel 2:

### Digital bebilderbares Flexodruckelement mit einer 3 µm dicken Barriereschicht aus Polyvinylalkohol

Zunächst wurde ein Folienelement präpariert, das übereinander angeordnet folgende Schichten umfasst:
- eine 100 µm dicke Mylar^{®} A PET-Folie;
- eine 3,2 µm dicke, digital bebilderbare Maskenschicht, enthaltend ein polymeres Bindemittel und Ruß;
- eine 3,0 µm dicke Sauerstoff-sperrende Schicht, enthaltend einen Polyvinylalkohol (Hydrolysegrad ca. 98 mol %).

Die digital bebilderbare Maskenschicht wurde wie folgt erhalten:
Zunächst wurde eine Lösung aus 91 kg Toluol, 91 kg n-Propanol und 23 kg Benzylalkohol hergestellt. Dieses Lösungsmittelgemisch wurde anschließend auf 70 °C aufgeheizt. Zu dieser Lösung wurden 23,4 kg eines weichelastischen Polyamids ( Macromelt^{®} 6900) gegeben. Im Anschluss daran wurden 12,6 kg Spezial Schwarz 4 in 4 Portionen unter Rühren zugegeben (jeweils pro Stunde eine Portion). Nach der letzten Portion wurde die Dispersion für 24 h bei 70 °C gerührt und anschließend auf 30 °C abgekühlt. Danach wurde der Reaktionsansatz für 5 h mit einer Rührwerkskugelmühle bei 240 kg/h Durchsatz gemahlen und über einen 10 µm-Filter filtriert. Die Reaktionslösung wurde kurz gerührt und anschließend mit einem Nassauftrag von 130 µm bei einer Geschwindigkeit von 6,3 m/min auf die 100 µm dicke Mylar^{®} PET-Folie aufgetragen. Die Trockenschichtdicke betrug 3,2 µm, welche über gravimetrische Messungen erhalten wurde.

Die Sauerstoff-sperrende Schicht wurde wie folgt erhalten:
Zunächst wurde eine Lösung von 0,0123 g eines handelsüblichen, nichtionischen, flourhaltigen Tensids (Capstone^{®} FS-30) in 4,50 g *n*-Propanol gelöst. Anschließend wurde diese Lösung zu 85,5 g Wasser gegeben. Zu diesen 90 Teilen Lösungsmittelgemisch (95 Teile Wasser, 5 Teile *n*-Propanol) wurden 5 Teile eines Polyvinylalkohols (Polyvinylalkohol aus Polyvinylacetat, Hydrolysegrad ca. 98 mol %, M_{w} ca. 27000 g/mol; Mowiol^{®} 4-98) unter Rühren gegeben und die entstandene Dispersion für 2 h auf 80 °C unter Rückfluss erhitzt (IKA HBR4 digital 80°C 400 rpm Heizbadflüssigkeit, IKA RW20 500 rpm). Anschließend wurde die auf Raumtemperatur abgekühlte Beschichtungslösung mit einer Geschwindigkeit von 33,7 mm/s und einem Nassauftrag von 65 µm auf die bebilderbare Maskenschicht, die sich auf einer 100 µm dicken PET-Folie befand, gerakelt. Die Trockenschichtdicke betrug 3,0 µm, welche gravimetrisch bestimmt wurde.

Das beschriebene Folienelement wurde auf die fotopolymerisierbare Schicht einer nyloflex^{®} ACE 114 Flexodruckplatte aufkaschiert. Hierzu wurden Deckfolie und die dünne Entklebungsschicht von der Flexodruckplatte abgezogen. Das Folienelement wurde auf die fotopolymerisierbare Oberfläche mittels eines Laminators aufkaschiert. Die Temperatur der Laminierwalzen wurde auf 110°C eingestellt. Der Verbund wurde noch für 3 h bei 65 °C temperiert.

Das Flexodruckelement wurde zunächst rückseitig 10 Sekunden vorbelichtet. Die Deckfolie wurde abgezogen. Das rückseitig vorbelichtete Flexodruckelement wurde auf die rotierbare Trommel eines IR-Lasers (Laser "nano", Flexolaser GmbH) aufgebracht. Die Lasertrommel hatte einen Durchmesser von ca. 500 mm. Hierbei bildeten sich auf der Oberfläche des Flexodruckelements zahlreiche Risse. Anschließend wurde in die Maskenschicht mithilfe des IR-Lasers ein Testmotiv eingeschrieben. Nach der Demontage des Flexodruckelementes von der Lasertrommel waren neben zahlreichen Rissen auch feine Wellenstrukturen auf der Oberfläche des Flexodruckelementes sichtbar.

Das bebilderte Flexodruckelement wurde anschließend analog Vergleichsversuch 1 mit aktinischer UV Strahlung 14 Minuten belichtet.

Anschließend wurde versucht, das belichtete Flexodruckelement in der gleichen Art und Weise wie bei Vergleichsversuch 1 mit einem handelsüblichen Auswaschmittel aus ca. 70 Gew. % Kohlenwasserstoffen und ca. 30 Gew. % eines Alkohols (nylosolv^{®} A) auszuwaschen. Das Auswaschen war aber nicht möglich. Die Sperrschicht aus Polyvinylalkohol ließ sich mit dem Auswaschmittel nicht entfernen, sondern verblieb auf der reliefbildenden Schicht (B).

Das Auswaschen erfolgte daher in mehreren Schritten. Zunächst wurden die Reste der laserablatierbaren Maskenschicht mit Benzylalkohol abgewaschen, danach wurde die Sperrschicht mit Wasser entfernt und schließlich das Relief durch Auswaschen in nylosolv^{®} (wie in Vergleichsbeispiel 1) erzeugt.

Die erhaltene Flexodruckplatte war zum Drucken völlig unbrauchbar. Zwar ergab die Auswertung des Klischees, dass sehr feine Raster auf dem Klischee abgebildet waren. Der kleinste, abgebildete Rastertonwert betrug 0,4% bei einer Rasterweite von 60 L/cm. Die einzelnen Rasterpunkte hatten flache Oberflächen und scharfe Ränder. Die Konturen der Rasterpunkte gaben die einzelnen Bildpunkte der Laserbebilderung wieder. Die im Zuge des Montierens auf die Lasertrommel gebildeten Risse sowie die feine Wellenstruktur waren aber auch auf der Oberfläche des Klischees sichtbar und würden zu schweren Fehlern im Druckbild führen.

### Beispiel 1:

### Digital bebilderbares Flexodruckelement mit 150 nm dicker Barriereschicht aus Polyvinylakohol

Zunächst wurde ein Folienelement präpariert, das übereinander angeordnet folgende Schichten umfasst:
- eine 100 µm dicke Mylar® A PET-Folie;
- eine 3,2 µm dicke, digital bebilderbare Maskenschicht, enthaltend ein polymeres Bindemittel und Ruß;
- eine 0,15 µm dicke Sauerstoff-sperrende Schicht, enthaltend einen Polyvinylalkohol (Hydrolysegrad ca. 98 mol %).
Die bebilderbare Maskenschicht wurde wie in Vergleichsbeispiel 2 beschrieben erhalten.

Die Sauerstoff-sperrende Schicht wurde wie folgt erhalten:
Zunächst wurde eine Lösung von 0,0121 g eines handelsüblichen, nichtionischen, fluorhaltigen Tensids (Capstone® FS-30) in 4,99 g *n*-Propanol gelöst. Anschließend wurde diese Lösung zu 94,81 g Wasser gegeben. Zu diesen 99,8 Teilen Lösungsmittelgemisch (95 Teile Wasser, 5 Teile *n*-Propanol) wurden 0,2 Teile eines Polyvinylalkohols (Polyvinyalkohol aus Polyvinylacetat, Hydrolysegrad ca. 98 mol %, M_{w} ca. 27000 g/mol; Mowiol^{®} 4-98) unter Rühren gegeben und die entstandene Dispersion für 2 h auf 80 °C unter Rückfluss erhitzt (IKA HBR4 digital 80°C 400rpm Heizbadflüssigkeit, IKA RW20 500 rpm). Anschließend wurde die auf Raumtemperatur abgekühlte Beschichtungslösung mit einer Geschwindigkeit von 33,7 mm/s und einem Nassauftrag von 75 µm auf die bebilderbare Maskenschicht, die sich auf einer 100 µm dicken PET-Folie befand, gerakelt. Die Trockenschichtdicke betrug 0,15 µm, welche über Reflexionsmessungen erhalten wurde.

Das beschriebene Folienelement wurde wie in Vergleichsbeispiel 2 beschrieben auf die fotopolymerisierbare Schicht einer nyloflex^{®} ACE 114 Flexodruckplatte aufkaschiert. Der Verbund wurde noch für 3 h bei 65 °C temperiert.

Das Flexodruckelement wurde zunächst 10 Sekunden rückseitig vorbelichtet. Die Deckfolie wurde abgezogen. Das rückseitig vorbelichtete Flexodruckelement wurde analog Vergleichsversuch 2 auf die rotierbare Trommel eines IR-Lasers ("nano", Flexolaser GmbH) aufgebracht. Im Gegensatz zu Vergleichsbeispiel 2 bildeten sich keine Risse. Die Flexodruckplatte war genauso flexibel wie ohne Sperrschicht. Anschließend wurde in die Maskenschicht mithilfe des IR-Lasers ein Testmotiv eingeschrieben. Nach der Demontage von der Lasertrommel war die Oberfläche des Flexodruckelementes unbeschädigt und ohne jegliche Struktur.

Das bebilderte Flexodruckelement wurde anschließend analog Vergleichsversuch 1 mit aktinischer UV Strahlung 14 Minuten belichtet.

Anschließend wurde das belichtete Flexodruckelement in der gleichen Art und Weise wie bei Vergleichsversuch 1 mit einem handelsüblichen Auswaschmittel aus ca. 70 Gew. % Kohlenwasserstoffen und ca. 30 Gew. % eines Alkohols (nylosolv^{®} A) ausgewaschen, getrocknet und nachbelichtet. Das erhaltene Flexodruckklischee lieferte hervorragende Druckergebnisse. Die Auswertung der Klischees ergab, dass sehr feine Raster auf dem Klischee abgebildet waren. Der kleinste, abgebildete Rastertonwert betrug 0,4% bei einer Rasterweite von 60 L/cm. Die einzelnen Rasterpunkte hatten flache Oberflächen und scharfe Ränder. Die Konturen der Rasterpunkte gaben die einzelnen Bildpunkte der Laserbebilderung wieder.

### Beispiel 2:

### Digital bebilderbares Flexodruckelement mit 150 nm dicker PVA-Barriereschicht und zusätzlicher 2 µm dicker Polyamid-Schutzschicht

In einem ersten Schritt wurde eine transparente Schutzschicht auf einer temporären Mylarfolie wie folgt hergestellt:
Eine Lösung aus 4 Teilen Toluol, 4 Teilen n-Propanol und 1 Teil Benzylalkohol wurde hergestellt. Dieses Lösungsmittelgemisch wurde anschließend auf 70 °C aufgeheizt. Zu dieser Lösung (98 Teile) wurden 2 Teile eines handelsüblichen, weichelastischen Polyamids (Macromelt^{®} 6900) gegeben und 2h unter Rückfluss erhitzt (IKA HBR4 digital 80°C 400 rpm Heizbadflüssigkeit, IKA RW20 500 rpm). Anschließend wurde die auf Raumtemperatur abgekühlte Beschichtungslösung mit einer Geschwindigkeit von 33,7 mm/s und einem Nassauftrag von 75 µm auf eine 100 µm dicken PET-Folie gerakelt. Die Trockenschichtdicke betrug 2,0 µm, welche gravimetrisch ermittelt wurde.

Auf die transparente Schutzschicht wurde die Sauerstoff sperrende Barriereschicht wie in Beispiel 1 aufgetragen.

Das erhaltene Deckelement wird auf die fotopolymerisierbare Schicht einer nyloflex^{®} ACE 114 Flexodruckplatte auflaminiert.

Eine laserbebilderbare Maskenschicht wird wie in Vergleichsbeispiel 2 auf eine 100 µm Mylar® PET-Folie aufgetragen.

Die temporäre Mylarfolie wird von der Flexodruckplatte abgezogen. Anschließend wird die laserbebilderbare Maskenschicht aufkaschiert.

Es wird ein Flexodruckelement mit folgendem Aufbau (von oben nach unten) erhalten:
- eine 100 µm dicke Mylar^{®} A PET-Folie;
- eine 3,2 µm dicke, digital bebilderbare Maskenschicht, enthaltend ein polymeres Bindemittel und Ruß;
- eine 2,0 µm dicke transparente Schutzschicht, enthaltend ein weichelastisches Polyamid ;
- eine 0,15 µm dicke Sauerstoff-sperrende Schicht, enthaltend einen Polyvinylalkohol.
- eine 965 µm dicke fotopolymerisierbare Schicht
- eine 175 µm dicke PET-Trägerfolie

Das Flexodruckelement wurde zunächst 10 Sekunden rückseitig vorbelichtet. Die Deckfolie wurde abgezogen. Das rückseitig vorbelichtete Flexodruckelement wurde analog Vergleichsversuch 2 auf die rotierbare Trommel eines IR-Lasers (Laser "nano", Flexolaser GmbH) aufgebracht. Im Gegensatz zu Vergleichsbeispiel 2 bildeten sich keine Risse. Die Flexodruckplatte war genauso flexibel wie ohne Sperrschicht. Anschließend wurde in die Maskenschicht mithilfe des IR-Lasers ein Testmotiv eingeschrieben.

Das bebilderte Flexodruckelement wurde anschließend analog Vergleichsversuch 1 mit aktinischer UV Strahlung 14 Minuten belichtet.

Anschließend wurde das belichtete Flexodruckelement in der gleichen Art und Weise wie bei Vergleichsversuch 1 mit einem handelsüblichen Auswaschmittel aus ca. 70 Gew. % Kohlenwasserstoffen und ca. 30 Gew. % eines Alkohols (nylosolv^{®} A) ausgewaschen.

Das Auswaschen in nylosolv^{®} war wie in Vergleichsbeispiel 1 möglich.

Die erhaltene Flexodruckplatte war zum Drucken hervorragend geeignet. Die Auswertung des Klischees ergab, dass sehr feine Raster auf dem Klischee abgebildet waren. Der kleinste, abgebildete Rastertonwert betrug 0,4% bei einer Rasterweite von 60 L/cm Die einzelnen Rasterpunkte hatten flache Oberflächen und scharfe Ränder. Die Konturen der Rasterpunkte gaben die einzelnen Bildpunkte der Laserbebilderung wieder. Die Oberfläche des Klischees war einwandfrei.

### Beispiel 3:

### Flexodruckelement mit einer etwa 300 nm dicken Barriereschicht aus einem hochverseiften Polyvinylacetat-Copolymeren

Zunächst wurde ein Folienelement präpariert, das übereinander angeordnet folgende Schichten umfasst:
- eine 100 µm dicke Mylar® A PET-Folie;
- eine 3,2 µm dicke, digital bebilderbare Maskenschicht, enthaltend ein polymeres Bindemittel und Ruß;
- eine 0,30 µm dicke Sauerstoff-sperrende Schicht, enthaltend ein hochverseiftes Polyvinylacetat-Copolymer.

Die bebilderbare Maskenschicht wurde wie in Vergleichsbeispiel 2 beschrieben erhalten.

Die Sauerstoff-sperrende Schicht wurde wie folgt erhalten:
0,5 Teile eines hochverseiften Polyvinylacetat Copolymers (Alcotex® 72.5, Hydrolysegrad 72,5 mol %) wurden zu 99,5 Teilen eines Lösungsmittelgemisches aus Wasser und *n*-Propanol im Verhältnis 1:1 unter Rühren gegeben. Anschließend wurden 0,01 Teile eines handelsüblichen, nichtionischen, fluorhaltigen Tensids (Capstone® FS-30) zugegeben und die entstandene Dispersion für 2 h auf 80 °C unter Rückfluss erhitzt (IKA HBR4 digital 80°C 400rpm Heizbadflüssigkeit, IKA RW20 500 rpm). Anschließend wurde die auf Raumtemperatur abgekühlte Beschichtungslösung mit einer Geschwindigkeit von 33,7 mm/s und einem Nassauftrag von 75 µm auf die bebilderbare Maskenschicht, die sich auf einer 100 µm dicken PET-Folie befand, gerakelt. Die Trockenschichtdicke betrug 0,3 µm, welche über Reflexionsmessungen erhalten wurde.

Das beschriebene Folienelement wurde wie in Vergleichsbeispiel 2 beschrieben auf die fotopolymerisierbare Schicht einer nyloflex ACE 114 Flexodruckplatte aufkaschiert. Der Verbund wurde noch für 3 h bei 65 °C temperiert.

Das Flexodruckelement wurde zunächst 10 Sekunden rückseitig vorbelichtet. Die Deckfolie wurde abgezogen. Das rückseitig vorbelichtete Flexodruckelement wurde analog Vergleichsversuch 2 auf die rotierbare Trommel eines IR-Lasers aufgebracht. Im Gegensatz zu Vergleichsbeispiel 2 bildeten sich keine Risse. Die Flexodruckplatte war genauso flexibel wie ohne Sperrschicht. Anschließend wurde in die Maskenschicht mithilfe des IR-Lasers ein Testmotiv eingeschrieben. Nach der Demontage von der Lasertrommel war die Oberfläche des Flexodruckelementes unbeschädigt und ohne jegliche Struktur.

Das bebilderte Flexodruckelement wurde anschließend analog Vergleichsversuch 1 mit aktinischer UV Strahlung 14 Minuten belichtet.

Anschließend wurde das belichtete Flexodruckelement in der gleichen Art und Weise wie bei Vergleichsversuch 1 mit einem handelsüblichen Auswaschmittel aus ca. 70 Gew. % Kohlenwasserstoffen und ca. 30 Gew. % eines Alkohols (nylosolv^{®} A) ausgewaschen, getrocknet und nachbelichtet. Die Auswertung der Klischees ergab, dass deutlich feinere Raster auf dem Klischee abgebildet waren als ohne Sperrschicht. Der kleinste, abgebildete Rastertonwert betrug 1.2% bei einer Rasterweite von 60 L/cm. Die einzelnen Rasterpunkte hatten flache Oberflächen und scharfe Ränder. Die Konturen der Rasterpunkte gaben die einzelnen Bildpunkte der Laserbebilderung wieder.

### Beispiel 4:

### Flexodruckelement mit einer 100nm dicken SiOₓ-Barriereschicht

Zunächst wurde ein Folienelement präpariert, das übereinander angeordnet folgende Schichten umfasst:
- eine 100 µm dicke Mylar® A PET-Folie;
- eine 3,2 µm dicke, digital bebilderbare Maskenschicht, enthaltend ein polymeres Bindemittel und Ruß;
- eine 100nm dicke SiOₓ-Barriereschicht.

Die bebilderbare Maskenschicht wurde wie in Vergleichsbeispiel 2 beschrieben erhalten.

Die SiOₓ Barriereschicht wurde nach der Ceramis^{®} Coating Technology auf die bebilderbare Maskenschicht aufgetragen. Hierzu wurde die mit der Maskenschicht beschichtete Polyesterfolie im Hochvakuum an einem SiOₓ Vorratsbehälter vorbeigefahren. Das feste SiOₓ wurde mittels Elektronenstrahlen verdampft und schlug sich auf der gekühlten, beschichteten Folie nieder. Das mit SiOₓ beschichtete Folienelement hatte eine gleichmäßige, matte Oberfläche. Die Dicke der SiOₓ Überschichtung, welche über Reflexionsmessungen erhalten wurde, betrug ca. 100 nm.

Das beschriebene Folienelement wurde wie in Vergleichsbeispiel 2 beschrieben auf die fotopolymerisierbare Schicht einer nyloflex^{®} ACE 114 Flexodruckplatte aufkaschiert. Der Verbund wurde noch für 3 h bei 65 °C temperiert.

Das Flexodruckelement wurde zunächst 10 Sekunden rückseitig vorbelichtet. Die Deckfolie wurde abgezogen. Das rückseitig vorbelichtete Flexodruckelement wurde analog Vergleichsversuch 2 auf die rotierbare Trommel eines IR-Lasers aufgebracht. Im Gegensatz zu Vergleichsbeispiel 2 bildeten sich keine Risse. Die Flexodruckplatte war genauso flexibel wie ohne Sperrschicht. Anschließend wurde in die Maskenschicht mithilfe des IR-Lasers ein Testmotiv eingeschrieben. Nach der Demontage von der Lasertrommel war die Oberfläche des Flexodruckelementes unbeschädigt und ohne jegliche Struktur.

Das bebilderte Flexodruckelement wurde anschließend analog Vergleichsversuch 1 mit aktinischer UV Strahlung 14 Minuten belichtet.

Anschließend wurde das belichtete Flexodruckelement in der gleichen Art und Weise wie bei Vergleichsversuch 1 mit einem handelsüblichen Auswaschmittel aus ca. 70 Gew. % Kohlenwasserstoffen und ca. 30 Gew. % eines Alkohols (nylosolv^{®} A) ausgewaschen, getrocknet und nachbelichtet. Die Auswertung der Klischees ergab, dass deutlich feinere Raster auf dem Klischee abgebildet waren als ohne Sperrschicht. Der kleinste, abgebildete Rastertonwert betrug 0.8% bei einer Rasterweite von 60 L/cm. Die einzelnen Rasterpunkte hatten flache Oberflächen und scharfe Ränder. Die Konturen der Rasterpunkte gaben die einzelnen Bildpunkte der Laserbebilderung wieder.

Die folgende Tabelle 1 fasst die Ergebnisse der Beispiele und Vergleichsbeispiele zusammen.

**Tabelle 1: Zusammenfassung der Ergebnisse der Beispiele und Vergleichsbeispiele**

| Nr | Barriereschicht | Schutzschicht | Laserbarkeit | Auswaschen | Rasterpunkt | Erster Tonwert bei 60L/cm |
|---|---|---|---|---|---|---|
| V1 | - | - | ok | nylosolv^{®} | rund | 7% |
| V2 | 3 µm Polyvinylalkohol | - | Risse | 1. Benzylalkohol, 2. Wasser, 3. nylosolv® | flach | 0.4% |
| Beispiel 1 | 150 nm Polyvinylalkohol | - | ok | nylosolv^{®} | flach | 0.4% |
| Beispiel 2 | 150 nm Polyvinylalkohol | 2 µm Polyamid | ok | nylosolv^{®} | flach | 0.4% |
| Beispiel 3 | 300 nm Poly(vinylalkohol-vinylacetat) | - | ok | nylosolv^{®} | flach | 1.2% |
| Beispiel 4 | 100 nm SiO_{X} | - | ok | nylosolv^{®} | flach | 0.8% |

Die Beispiele und Vergleichsbeispiele zeigen, das Flexodruckelemente, welche keine Barriereschicht aufweisen und in Gegenwart von Luftsauerstoff belichtet werden nur, unbefriedigende Tonwerte aufweisen.

Eine 3 µm dicke Barriereschicht aus Polyvinylalkohol liefert zwar gute Tonwerte, aber bei der Bebilderung der laserablatierbaren Maskenschicht mittels eines Trommellasers bilden sich Risse, die zu Störungen im Druckbild führen.

Dünne Barriereschichten aus Polyvinylalkohol, Poly(vinylalkohol-vinylacetat)-Copolymeren sowie SiOₓ führen sowohl zu befriedigenden Tonwerten wie auch zu störungsfreiem Druck.

## Patentansprüche

1. Digital bebilderbares, fotopolymerisierbares, unter Verwendung von Kohlenwasserstoffe umfassenden Auswaschmitteln entwickelbares Flexodruckelement, umfassend - in der genannten Reihenfolge übereinander angeordnet - mindestens
(A) eine dimensionsstabile Trägerfolie mit einer Dicke von 50 µm bis 300 µm,
(B) eine in organischen Lösemitteln lösliche oder dispergierbare, fotopolymerisierbare, reliefbildende Schicht einer Schichtdicke von 300 µm bis 6000 µm, umfassend mindestens ein elastomeres Bindemittel, ein ethylenisch ungesättigtes Monomer sowie einen Fotoinitiator oder ein Fotoinitiatorsystem,
(C) eine transparente Barriereschicht für Sauerstoff,
(D) eine in organischen Lösemitteln lösliche oder dispergierbare, laserablatierbare Maskenschicht einer Schichtdicke von 1 µm bis 4 µm, umfassend mindestens ein elastisches Bindemittel und UV/VIS-Licht absorbierende Materialien, wobei die Schichtdicke und/oder die Menge der lichtabsorbierenden Materialien so bemessen werden, dass die optische Dichte der Schicht für UV/VIS-Strahlung 2 bis 4 beträgt, sowie
(E) eine abziehbare Deckfolie,
wobei die Barriereschicht (C) polar ist und in Wasser und/oder mindestens 50 Gew. % Wasser umfassenden Wasser-Alkohol Gemischen löslich ist, und die Barriereschicht (C) eine Schichtdicke von 10 nm bis 999 nm aufweist,
**dadurch gekennzeichnet, dass** das Flexodruckelement zwischen den Schichten (C) und (D) eine transparente Schicht (X) zum Schutz der Barriereschicht (C) vor Laserstrahlung umfasst, wobei die Schutzschicht (X) mindestens ein elastisches, polymeres Bindemittel umfasst und eine Schichtdicke von 0,1 µm bis 4 µm aufweist.

2. Flexodruckelement gemäß Anspruch 1, **dadurch gekennzeichnet, dass** es sich bei dem Material der Barriereschicht (C) um mindestens ein Material ausgewählt aus der Gruppe von Polyvinylalkohol, teil- und hochverseiftem Polyvinylcarboxylat, Poly(ethylenoxid-vinylalcohol) Pfropfcopolymeren oder Poly(ethylen-vinylalkohol)-Copolymeren handelt.

3. Flexodruckelement gemäß Anspruch 1, **dadurch gekennzeichnet, dass** es sich bei dem Material der Barriereschicht (C) um anorganische Metall und / oder Halbmetalloxide handelt.

4. Flexodruckelement gemäß Anspruch 3, **dadurch gekennzeichnet, dass** es sich bei dem Halbmetalloxid um SiOₓ handelt.

5. Flexodruckelement gemäß einem der Ansprüche 1 bis 4, **dadurch gekennzeichnet, dass** die Sauerstoffpermeabilität der Barriereschicht (C) bei 295 K kleiner als 100 (cm³ x 100 µm) / (m² x d x bar) ist.

6. Flexodruckelement gemäß einem der Ansprüche 1 bis 5, **dadurch gekennzeichnet, dass** die Dicke der Barriereschicht (C) von 100 nm bis 400 nm beträgt.

7. Flexodruckelement gemäß einem der Ansprüche 1 bis 5, **dadurch gekennzeichnet, dass** die Dicke der Barriereschicht (C) von 100 nm bis 249 nm beträgt.

8. Flexodruckelement gemäß einem der Ansprüche 1 bis 7, **dadurch gekennzeichnet, dass** es sich bei mindestens einem Bindemittel der laserablatierbaren Maskenschicht (D) ein weichelastisches Polyamid handelt.

9. Verfahren zur Herstellung von Flexodruckplatten, bei dem man als Ausgangsmaterial ein Flexodruckelement gemäß einem der Ansprüche 1 bis 8 einsetzt, umfassend mindestens die folgenden Verfahrensschritte:
(1) Abziehen der Deckfolie (E),
(2) Einschreiben einer Maske in die laserablatierbare Maskenschicht (D) mithilfe eines IR-Lasers,
(3) Belichten des bebilderten Flexodruckelements mit UV- bzw. UV-VIS-Strahlung durch die gebildete Maske hindurch,
(4) Entfernen der Reste der laserablatierbaren Maskenschicht (E), der gegebenenfalls vorhandenen Schutzschicht (X) und der Barriereschicht (C) sowie der nicht polymerisierten Anteile der reliefbildenden Schicht (B) unter Verwendung eines Auswaschmittels, welches mindestens 60 Gew. % Kohlenwasserstoffe umfasst,
(5) Trocknen der erhaltenen Flexodruckplatte, sowie
(6) Nachbehandeln mit UV-A und/oder UV-C-Licht.

10. Verfahren gemäß Anspruch 9, **dadurch gekennzeichnet, dass** das Auswaschmittel 60 bis 95 Gew. % Kohlenwasserstoffe sowie 5 bis 40 Gew. % Alkohole umfasst.

11. Verfahren gemäß Anspruch 9 oder 10, **dadurch gekennzeichnet, dass** für Verfahrensschritt (2) eine Laserapparatur umfassend eine rotierbare Trommel eingesetzt wird, und man das Flexodruckelement zum Bebildern auf die Trommel montiert.

12. Verfahren gemäß einem der Ansprüche 9 bis 11, **dadurch gekennzeichnet, dass** für Verfahrensschritt (3) ein Flachbettbelichter verwendet wird.

13. Verfahren gemäß einem der Ansprüche 9 bis 12, **dadurch gekennzeichnet, dass** für Verfahrensschritt (4) ein Flachbett-Auswaschgerät verwendet wird.

## Claims

1. Digitally imageable, photopolymerizable, flexographic printing element which is developable using hydrocarbon-comprising washout media and which comprises - disposed one above another in the order stated - at least
(A) a dimensionally stable support film having a thickness from 50 µm to 300 µm,
(B) a photopolymerizable, relief-forming layer from 300 µm to 6000 µm in thickness, which is soluble or dispersible in organic solvents and which comprises at least one elastomeric binder, an ethylenically unsaturated monomer, and a photoinitiator or a photoinitiator system,
(C) a transparent barrier layer for oxygen,
(D) a laser-ablatable mask layer from 1 µm to 4 µm in thickness, which is soluble or dispersible in organic solvents and comprises at least an elastic binder and UV/VIS light-absorbing materials, the layer thickness and/or the amount of light-absorbing materials being made such that the optical density of the layer for UV/VIS radiation is 2 to 4, and
(E) a removable top film,
the barrier layer (C) being polar and being soluble in water and/or in water/alcohol mixtures comprising at least 50 wt% of water, and the barrier layer (C) having a thickness from 10 nm to 999 nm, **characterized in that** between the layers (C) and (D), the flexographic printing element comprises a transparent layer (X) for protecting the barrier layer (C) from laser radiation, the protective layer (X) comprising at least one elastic, polymeric binder and having a thickness from 0.1 µm to 4 µm.

2. Flexographic printing element according to Claim 1, **characterized in that** the material of the barrier layer (C) comprises at least one material selected from the group consisting of polyvinyl alcohol, partly and highly hydrolyzed polyvinyl carboxylate, poly(ethylene oxide-vinyl alcohol) graft copolymers, and poly(ethylene-vinyl alcohol) copolymers.

3. Flexographic printing element according to Claim 1, **characterized in that** the material of the barrier layer (C) comprises inorganic metal and/or semimetal oxides.

4. Flexographic printing element according to Claim 3, **characterized in that** the semimetal oxide comprises SiOₓ.

5. Flexographic printing element according to any of Claims 1 to 4, **characterized in that** the oxygen permeability of the barrier layer (C) at 295 K is less than 100 (cm³ × 100 µm) / (m² × d × bar).

6. Flexographic printing element according to any one of Claims 1 to 5, **characterized in that** the thickness of the barrier layer (C) is from 100 nm to 400 nm.

7. Flexographic printing element according to any one of Claims 1 to 5, **characterized in that** the thickness of the barrier layer (C) is from 100 nm to 249 nm.

8. Flexographic printing element according to any of Claims 1 to 7, **characterized in that** at least one binder of the laser-ablatable mask layer (D) comprises a soft elastic polyamide.

9. Method for producing flexographic printing plates, using as starting material a flexographic printing element according to any of Claims 1 to 8, comprising at least the following method steps:
(1) removing the top film (E),
(2) writing a mask into the laser-ablatable mask layer (D) by means of an IR laser,
(3) exposing the imaged flexographic printing element to UV or UV-VIS radiation through the resultant mask,
(4) removing the remnants of the laser-ablatable mask layer (E), the protective layer (X) where present, and the barrier layer (C) and also the unpolymerized fractions of the relief-forming layer (B), using a washout medium which comprises at least 60 wt% hydrocarbons,
(5) drying the resultant flexographic printing plate, and
(6) carrying out post-treatment with UV-A and/or UV-C light.

10. Method according to Claim 9, **characterized in that** the washout medium comprises 60 to 95 wt% hydrocarbons and 5 to 40 wt% alcohols.

11. Method according to Claim 9 or 10, **characterized in that** for method step (2) a laser apparatus comprising a rotatable drum is used and Flexographic printing element for imaging is mounted to the drum.

12. Method according to any of Claims 9 to 11, **characterized in that** for method step (3) a flatbed exposure unit is used.

13. Method according to any of Claims 9 to 12, **characterized in that** for method step (4) a flatbed washout apparatus is used.

## Revendications

1. Élément flexographique photopolymérisable, apte à recevoir une image numérique, pouvant être développé avec utilisation de produits de lavage comprenant des hydrocarbures, comprenant - disposés en étant superposés dans l'ordre indiqué - au moins
(A) un film de support à stabilité dimensionnelle, ayant une épaisseur de 50 µm à 300 µm,
(B) une couche formant relief photopolymérisable, soluble ou dispersable dans des solvants organiques, ayant une épaisseur de couche de 300 µm à 6 000 µm, comprenant au moins un liant élastomère, un monomère à insaturation éthylénique ainsi qu'un photoamorceur ou un système photoamorceur,
(C) une couche barrière à l'oxygène, transparente,
(D) une couche de masquage apte à l'ablation laser, soluble ou dispersable dans des solvants organiques, ayant une épaisseur de couche de 1 µm à 4 µm, comprenant au moins un liant élastique et des matériaux absorbant la lumière UV/VIS, l'épaisseur de couche et/ou la quantité des matériaux photo-absorbants étant choisies de manière que la densité optique de la couche pour un rayonnement UV/VIS vaille de 2 à 4, ainsi que
(E) un film de recouvrement pelable,
la couche barrière (C) étant polaire et étant soluble dans l'eau et/ou des mélanges d'eau-alcool comprenant au moins 50 % en poids d'eau, et la couche barrière (C) présentant une épaisseur de couche de 10 nm à 999 nm,
**caractérisé en ce que** l'élément flexographique comprend entre les couches (C) et (D) une couche transparente (X) destinée à la protection de la couche barrière (C) contre le rayonnement laser, la couche protectrice (X) comprenant au moins un liant polymère élastique et présentant une épaisseur de couche de 0,1 µm à 4 µm.

2. Élément flexographique selon la revendication 1, **caractérisé en ce que** pour ce qui est du matériau de la couche barrière (C) il s'agit au moins d'un matériau choisi dans le groupe constitué par le poly(alcool vinylique), un poly(carboxylate de vinyle) partiellement ou hautement saponifié, des copolymères greffés poly(oxyde d'éthylène-alcool vinylique) ou des copolymères poly(éthylène-alcool vinylique).

3. Élément flexographique selon la revendication 1, **caractérisé en ce que** pour ce qui est du matériau de la couche barrière (C) il s'agit d'un métal inorganique et/ou d'oxydes de métalloïdes.

4. Élément flexographique selon la revendication 3, **caractérisé en ce que** pour ce qui est de l'oxyde de métalloïde il s'agit de SiO₂.

5. Élément flexographique selon l'une quelconque des revendications 1 à 4, **caractérisé en ce que** la perméabilité de la couche barrière (C) à l'oxygène à 295 K est inférieure à 100 (cm³ x 100 µm) / (m² x d x bar).

6. Élément flexographique selon l'une quelconque des revendications 1 à 5, **caractérisé en ce que** l'épaisseur de la couche barrière (C) vaut de 100 nm à 400 nm.

7. Élément flexographique selon l'une quelconque des revendications 1 à 5, **caractérisé en ce que** l'épaisseur de la couche barrière (C) vaut de 100 nm à 249 nm.

8. Élément flexographique selon l'une quelconque des revendications 1 à 7, **caractérisé en ce que** pour ce qui est d'au moins un liant de la couche de masquage (D) apte à l'ablation laser il s'agit d'un polyamide élastique souple.

9. Précédé pour la fabrication de plaques flexographiques, dans lequel on utilise comme produit de départ un élément flexographique selon l'une quelconque des revendications 1 à 8, comprenant au moins les étapes de processus suivantes :
(1) pelage du film de recouvrement (E),
(2) inscription d'un masque dans la couche de masquage (D) apte à l'ablation laser, à l'aide d'un laser IR,
(3) insolation de l'élément flexographique ayant reçu l'image, par irradiation UV ou UV-VIS à travers le masque formé,
(4) élimination des résidus de la couche de masquage (E) apte à l'ablation laser, de la couche protectrice (X) éventuellement présente et de la couche barrière (C) ainsi que des parties non polymérisées de la couche formant relief (B), avec utilisation d'un produit de lavage qui comprend au moins 60 % en poids d'hydrocarbures,
(5) séchage de la plaque flexographique obtenue, ainsi que
(6) post-traitement par de la lumière UV-A et/ou de la lumière UV-C.

10. Procédé selon la revendication 9, **caractérisé en ce que** le produit de lavage comprend 60 à 95 % en poids d'hydrocarbures ainsi que 5 à 40 % en poids d'alcools.

11. Procédé selon la revendication 9 ou 10, **caractérisé en ce que** pour l'étape (2) du processus on utilise un appareil laser comprenant un tambour rotatif et pour la formation de l'image on monte l'élément flexographique sur le tambour.

12. Procédé selon l'une quelconque des revendications 9 à 11, **caractérisé en ce que** pour l'étape (3) du processus on utilise un appareil d'insolation à plat.

13. Procédé selon l'une quelconque des revendications 9 à 12, **caractérisé en ce que** pour l'étape (4) du processus on utilise un appareil de lavage à plat.
